# FASCICULE DE BREVET EUROPEEN

(11) **EP 1 936 691 B1**
(45) Date de publication et mention de la délivrance du brevet: **01.12.2010**
(21) Numéro de dépôt: 07123345.6
(22) Date de dépôt: 17.12.2007
(51) Int. Cl.: H01L 27/115, H01L 21/8247

(54) **Dispositif de memorisation à structure multi-niveaux**
Speichervorrichtung mit mehrstufiger Struktur
Memorisation device with multi-level structure

(30) Priorité: 20.12.2006 FR 0655688
(43) Date de publication de la demande: 25.06.2008
(73) Titulaire: Commissariat à l'Énergie Atomique et aux Énergies Alternatives, 75015 Paris (FR)
(72) Inventeur: Gidon, Serge, 38140 La Murette (FR)
(74) Mandataire: Ilgart, Jean-Christophe

(56) Documents cités:
- EP-A- 1 482 555
- EP-A- 1 507 294
- WO-A-2004/040667
- US-A1- 2005 051 806
- VETTIGER P ET AL: "The Millipede-Nanotechnology EnteringData Storage" IEEE TRANSACTIONS ON NANOTECHNOLOGY, IEEE, NEW YORK, NY, US, vol. 1, no. 1, mars 2002 (2002-03), XP011077067 ISSN: 1536-125X

## Description

### DOMAINE TECHNIQUE ET ART ANTÉRIEUR

L'invention concerne le domaine de l'enregistrement de données, et plus particulièrement un support d'enregistrement de données sur plusieurs niveaux.

Dans le domaine de l'informatique, des capacités mémoires de plus en plus importantes sont nécessaires. Il existe plusieurs types de mémoire pour enregistrer des données : des mémoires de masse, par exemple un disque dur ou un disque optique, ou des mémoires dynamiques, par exemple une mémoire DRAM (« Dynamic Random Access Memory » en anglais, ou mémoire à accès aléatoire dynamique) ou de type Flash. Les mémoires dynamiques sont également appelées « mémoires solides » dans la mesure où aucun élément mécanique mobile n'est utilisé.

Les mémoires de type Flash sont généralement basées sur un circuit électronique réalisé en surface d'un substrat de silicium et interconnecté par des lignes électriques, par exemple des pistes de cuivre ou des plots de nickel, placées au-dessus de cette surface. Ce circuit électronique peut par exemple être réalisé à partir de transistors MOS à grille flottante.

Dans ce type de transistor MOS, la grille flottante est isolée électriquement du canal du transistor par une première couche diélectrique, appelée « oxyde tunnel », et isolée électriquement de la grille de commande du transistor par une seconde couche diélectrique, appelée « oxyde interpoly » car comportant un empilement de fines couches d'oxyde, de nitrure, et d'oxyde. La grille flottante et ces deux couches diélectriques sont disposées entre la grille de commande et le canal du transistor. La grille flottante est l'élément de stockage de l'information. La charge électrique stockée dans cette grille flottante représente l'information et induit un décalage de la caractéristique de transfert du transistor vu depuis la grille de commande. La lecture de l'information stockée dans la grille flottante se base donc sur ce décalage. Les opérations d'écriture et d'effacement sont effectuées par transfert de charges électriques à travers l'oxyde tunnel, pour charger ou décharger la grille flottante. De tels transistors sont décrits dans les documents WO 90/11621 et « Transistors MOS et sa technologie de fabrication » de Skotnicki, Techniques de l'Ingénieur. Electronique, 2000, Vol. 2, n°E2430.

Pour augmenter la capacité d'une mémoire, il est connu d'accroître la densité d'intégration surfacique des éléments de stockage. Par exemple, pour les mémoires solides, le progrès des techniques lithographiques permet une diminution de la taille des circuits, par exemple des transistors, augmentant ainsi la densité d'intégration surfacique possible sur ce type de mémoire. Toutefois, avec ce type de mémoire, les augmentations de la capacité de stockage sont liées uniquement à l'augmentation de la densité d'intégration surfacique des éléments de stockage.

Il existe également des mémoires dites « à micro-pointes », comportant un support de stockage adressé au moyen d'un réseau de micro-pointes mobiles. Ces micro-pointes modifient localement des propriétés physico-chimiques (par exemple mécanique, thermique ou électrique) de la surface du support de stockage pour y écrire des informations. Ces informations peuvent ensuite être lues par détection des modifications des propriétés physico-chimiques réalisées sur la surface du support. Dans ce type de mémoire, les extrémités des micro-pointes définissent la limite de la densité surfacique des éléments de stockage. La densité surfacique obtenue (par exemple de l'ordre de 0,15 Tbits/cm²) prédispose ces mémoires à des applications de grande capacité dans un petit volume, par exemple destinées à des dispositifs "nomades". Par ailleurs, leur technologie de fabrication ne nécessitant pas de moyens lithographiques avancés, leur coût de fabrication reste peu élevé.

Le document « The "Millipede" - More than one thousand tips for future AFM data storage » de P. Vettiger et al., IBM J. Res. Develop., vol. 44, n°3, mai 2000, pages 323 à 340, décrit une mémoire à micro-pointes mettant en oeuvre les techniques de la microscopie à force atomique (AFM) sur la surface d'une couche de stockage à base de matériaux polymères. Les informations stockées dans cette mémoire se présentent sous forme de trous réalisés dans la couche de stockage.

Il est également possible de modifier d'autres propriétés d'une telle couche de stockage, comme par exemple la conduction, modifiée par un champ électrique généré par les micro-pointes.

Mais là encore, les augmentations des capacités de stockage de telles mémoires à micro-pointes sont liées uniquement à l'augmentation de la densité d'intégration surfacique des éléments de stockage et à la réduction des dimensions des extrémités des micro-pointes.

Le document US 2005/051806 A1 décrit un dispositif de mémorisation de données comportant plusieurs cellules mémoires, chacune formée par un transistor, reliées en série les unes aux autres et disposées entre deux transistors de sélection.

### EXPOSÉ DE L'INVENTION

Un but de la présente invention est de proposer un dispositif dont la capacité de stockage ne soit pas liée uniquement à la densité d'intégration surfacique des éléments de stockage du dispositif et aux dimensions de la surface du dispositif de stockage.

Pour cela, la présente invention propose un dispositif de mémorisation de données selon la revendication 1.

On utilise un support de mémorisation constitué de « colonnes actives » de stockage, et comportant de multiples niveaux mémoire, chaque seconde couche de l'empilement formant une grille de commande permettant de commander les zones de mémorisation formées par les couches de stockage de charges électriques qui entourent les portions de matériau semi-conducteur des colonnes actives, par exemple sur toute l'épaisseur de l'empilement de couches. On a donc un élément de mémorisation à chaque intersection d'une colonne active avec une seconde couche de l'empilement.

Ainsi, on réalise une intégration tridimensionnelle des circuits de stockage avec un empilement des zones mémoires, permettant que l'augmentation de la capacité de stockage ne soit plus uniquement liée à l'augmentation de la densité d'intégration surfacique des éléments de stockage du dispositif.

Il est donc possible d'obtenir avec un tel dispositif de très grandes capacités de stockage à faible coût, dans un volume réduit, sans étendre la surface de chaque couche de stockage.

De plus, avec un tel empilement de niveaux mémoire, une altération ou un mauvais fonctionnement de l'un des niveaux mémoire, au niveau d'une des secondes couches de l'empilement, n'a pas d'impact sur le fonctionnement des autres niveaux mémoires, le dispositif pouvant donc continuer à fonctionner.

La couche de stockage de charges électriques de chaque colonne peut être isolée électriquement de l'empilement par une première couche diélectrique entourant ladite couche de stockage de charges électriques, par exemple sur toute l'épaisseur de l'empilement de couches, et peut être isolée électriquement de la portion de matériau semi-conducteur par une seconde couche diélectrique entourant ladite portion de matériau semi-conducteur, par exemple sur toute l'épaisseur de l'empilement de couches.

Chaque colonne peut comporter des zones de dopage réalisées dans la portion de matériau semi-conducteur, au niveau des premières couches de l'empilement, et formant une pluralité de transistors de type MOS à grille flottante, les secondes couches de l'empilement formant les grilles de commande et les couches de stockage de charges électriques des colonnes formant les grilles flottantes de ces transistors.

Dans ce cas, chaque colonne forme donc une pluralité de transistors MOS à grille flottante reliés en série.

La présente invention concerne également un procédé de réalisation d'un dispositif de mémorisation de données, comportant au moins les étapes selon la revendication 25.

L'étape de réalisation de l'empilement peut être mise en oeuvre avant l'étape de réalisation des colonnes, le procédé pouvant comporter en outre, entre l'étape de réalisation de l'empilement et l'étape de réalisation de colonnes, une étape de gravure d'une pluralité de trous dans l'empilement, les trous pouvant traverser chaque couche de l'empilement, les colonnes pouvant être ensuite réalisées dans les trous.

La réalisation des colonnes peut être obtenue par au moins les étapes de :
- dépôt d'une première couche diélectrique sur les parois des trous formés dans l'empilement de couches,
- dépôt de la couche de stockage de charges électriques sur la première couche diélectrique,
- dépôt d'une seconde couche diélectrique sur la couche de stockage de charges électriques,
- retrait des portions de couches diélectriques et de la couche de stockage de charges électriques se trouvant au fond des trous,
- réalisation des portions de matériau semi-conducteur dans les trous.

La présente invention concerne également un procédé de réalisation de dispositif de mémorisation de données, comportant au moins les étapes de :
- réalisation de colonnes, chacune étant formée par au moins une portion de matériau semi-conducteur entourée d'une couche de stockage de charges électriques isolée électriquement de la portion de matériau semi-conducteur,
- réalisation d'un empilement de couches formé par une alternance de premières couches de conductivité inférieure à environ 0,01 (Ω.cm)⁻¹, ou inférieure à environ 0,1 (Ω.cm)⁻¹, ou inférieure à environ 1.10⁻³ (Ω.cm)⁻¹, et de secondes couches de conductivité supérieure à environ 1 (Ω.cm)⁻¹, ou supérieure à environ 0,1 (Ω.cm)⁻¹, ou supérieure à environ 10 (Ω.cm)⁻¹, entourant les colonnes, la couche de stockage de charges électriques étant isolée électriquement dudit empilement.

L'étape de réalisation des colonnes peut être mise en oeuvre avant l'étape de réalisation de l'empilement, les couches de l'empilement pouvant être réalisées en entourant les colonnes.

La réalisation des colonnes peut être obtenue par au moins les étapes de :
- réalisation des portions de matériau semi-conducteur,
- dépôt d'une couche diélectrique, appelée seconde couche diélectrique, au moins sur les parois latérales des portions de matériau semi-conducteur,
- dépôt de la couche de stockage de charges électriques sur la seconde couche diélectrique,
- dépôt d'une autre couche diélectrique, appelée première couche diélectrique, sur la couche de stockage de charges électriques.

La réalisation des portions de matériau semi-conducteur peut être une croissance de nanofils ou de nanotubes du matériau semi-conducteur réalisée à partir d'un matériau métallique, par exemple à base d'or et/ou de nickel et/ou de platine, déposé par pulvérisation sur un substrat à base d'au moins un matériau semi-conducteur.

Le procédé peut comporter en outre une étape de dopage de zones dans les portions de matériau semi-conducteur, au niveau des premières couches de l'empilement.

Le procédé peut comporter en outre, après la réalisation de l'empilement et des colonnes, une étape de planarisation mécano-chimique de la surface du dispositif et/ou une étape de dépôt, par exemple par pulvérisation, d'une couche au moins partiellement conductrice, par exemple à base de carbone et de particules métalliques, sur l'empilement et sur les sommets des colonnes.

Le procédé peut comporter en outre une étape de réalisation de moyens d'application de tension aux bornes des secondes couches de l'empilement, et/ou une étape de réalisation de moyens d'application de tension aux bornes des colonnes et/ou une étape de réalisation de moyens de mesure du courant destiné à circuler dans les colonnes.

La réalisation des portions de matériau semi-conducteur peut être une croissance de nanofils de silicium ou de nanotubes de carbone réalisée à partir d'un matériau métallique déposé par pulvérisation sur un substrat à base d'au moins un matériau semi-conducteur.

Enfin, le procédé peut comporter en outre une étape de réalisation de moyens de sélection d'une ou plusieurs colonnes et/ou une étape de réalisation de moyens de sélection d'une ou plusieurs secondes couches de l'empilement.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 est une vue en coupe d'une partie d'un dispositif de mémorisation de données, objet de la présente invention, selon un premier mode de réalisation,
- la figure 2 est une vue en coupe d'une partie d'un dispositif de mémorisation de données, objet de la présente invention, selon un second mode de réalisation,
- la figure 3 est une vue de dessous d'une partie d'un dispositif de mémorisation de données, objet de la présente invention, selon le second mode de réalisation,
- les figures 4A à 4F représentent des étapes d'un procédé de réalisation d'un dispositif de mémorisation de données, objet de la présente invention, selon le premier mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

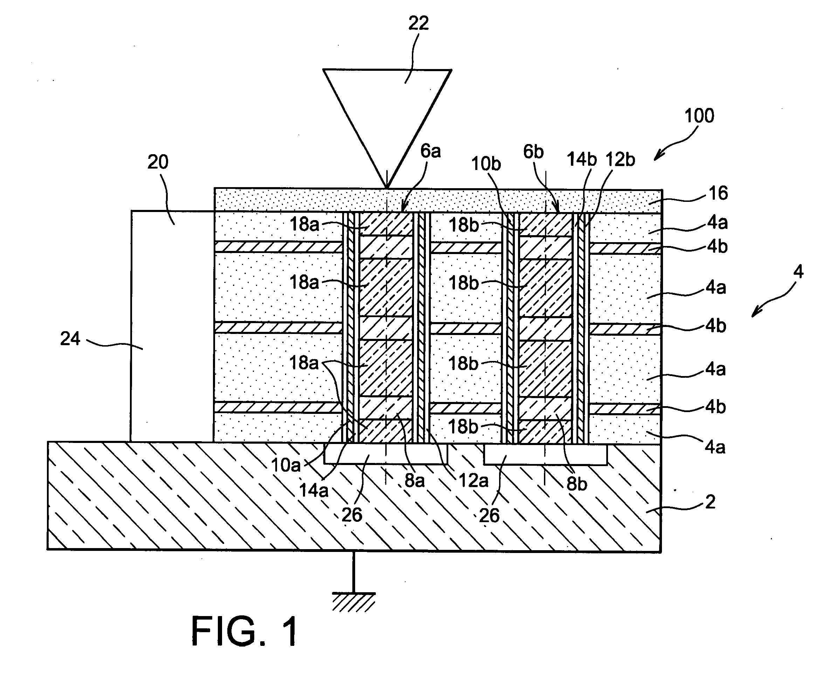

On se réfère tout d'abord à la figure 1 qui représente une vue en coupe d'un dispositif de mémorisation de données 100 selon un premier mode de réalisation.

Le dispositif 100 comporte un substrat 2 à base d'au moins un matériau semi-conducteur, par exemple du silicium d'orientation cristalline (*111*)*.*

Un empilement 4, formé par une alternance de premières couches 4a de conductivité inférieure à environ 0, 01 (Ω.cm)⁻¹ et de secondes couches 4b de conductivité supérieure à environ 1 (Ω.cm)⁻¹, est disposé sur le substrat 2.

Dans ce premier mode de réalisation, les premières couches 4a de l'empilement 4, au nombre de quatre, sont à base d'oxyde de silicium (SiO₂), et/ou de nitrure de silicium (SiN), et/ou de tout autre matériau diélectrique à permittivité réduite (matériau « Low k »), c'est-à-dire de permittivité inférieure à environ 4, tel que par exemple de l'oxycarbure de silicium (SiOC) ou de l'oxyde hydrocarboné de silicium (SiOCH).

Les secondes couches 4b de l'empilement 4, ici au nombre de trois, sont à base silicium polycristallin, et/ou d'aluminium, et/ou de cuivre, et/ou de carbone, et/ou de carbonitrure de silicium (SiCN) et/ou de tout autre métal. Dans la suite de ce document, les premières couches 4a de l'empilement 4 seront appelées couches isolantes 4a et les secondes couches 4b de l'empilement 4 seront appelées couches conductrices 4b. Dans ce premier mode de réalisation, chaque couche conductrice 4b est disposée entre deux couches isolantes 4a.

De manière générale, l'empilement 4 peut être formé par au moins deux couches conductrices 4b, chaque couche conductrice 4b étant disposée entre deux couches isolantes 4a. Par exemple, les couches isolantes 4a peuvent avoir une épaisseur comprise entre environ 10 nm et 100 nm et les couches conductrices 4b peuvent avoir une épaisseur comprise entre environ 3 nm et 30 nm.

Le dispositif 100 comporte également une pluralité de colonnes traversant, par exemple perpendiculairement, les couches 4a, 4b de l'empilement 4. Sur la figure 1, seules deux colonnes 6a et 6b sont représentées. Chacune des colonnes 6a, 6b est formée par une portion de matériau semi-conducteur 8a, 8b entourée d'une couche de stockage de charges électriques 10a, 10b. Dans ce premier mode de réalisation, chaque couche de stockage de charges électriques 10a, 10b comporte, au niveau des couches isolantes 4a, des portions isolantes, et au niveau des couches conductrices 4b, des portions conductrices. Pour des raisons de simplification, ces portions ne sont pas représentées sur les couches 10a, 10b de la figure 1. On a ainsi des couches de stockage de charges électriques 10a, 10b comportant une pluralité de portions conductrices séparées les unes des autres par des portions isolantes.

Chaque couche de stockage de charges électriques 10a, 10b est isolée électriquement de l'empilement 4 et des portions de matériau semi-conducteur 8a, 8b respectivement par une première couche diélectrique 12a, 12b et une seconde couche diélectrique 14a, 14b. Chaque seconde couche diélectrique 14a, 14b entoure toute la surface de chaque portion de matériau semi-conducteur 8a, 8b se trouvant au niveau de l'empilement 4, c'est-à-dire sur toute l'épaisseur de l'empilement 4. Chaque seconde couche diélectrique 14a, 14b est entourée par une couche de stockage de charges électriques 10a, 10b, elle-même entourée d'une première couche diélectrique 12a, 12b.

Dans ce premier mode de réalisation, les portions de matériau semi-conducteur 8a, 8b sont à base de silicium, par exemple des nanofils de silicium. Les portions 8a, 8b peuvent également être à base de nanotubes de carbone. Les portions isolantes des couches de stockage de charges électriques 10a, 10b sont par exemple à base d'oxyde de silicium, et/ou de SiN et/ou d'oxyde d' aluminium (Al₂O₃). Les portions conductrices des couches de stockage de charges électriques 10a, 10b sont ici à base de silicium polycristallin et/ou de silicium-germanium (SiGe) et/ou de tout autre matériau électriquement conducteur.

Dans une variante de réalisation, les couches de stockages de charges électriques peuvent ne pas comporter de portions conductrices et de portions isolantes, mais être à base d'oxyde de silicium de type SiOₓ avec x < 2 et/ou de nitrure de silicium, chargé en silicium, et/ou de tout autre matériau diélectrique de permittivité supérieure à environ 4 (« High k ») tel que de l'oxynitrure de silicium (SiON) et/ou d'HfSiOₓ (avec 1≤ x ≤ 3) et/ou d'oxyde de tantale (Ta₂O₅) comportant des nanoparticules de silicium ou de tout autre matériau métallique.

Les secondes couches diélectriques 14a, 14b séparant les couches de stockage de charges électriques 10a, 10b et les portions de matériau semi-conducteur 8a, 8b sont par exemple à base d'au moins un matériau diélectrique, tel que de l'oxyde de silicium et/ou de SiN et/ou de tout autre matériau « High k ». Enfin, dans ce premier mode de réalisation, les premières couches diélectriques 12a, 12b séparant les couches de stockage de charges électriques 10a, 10b et l'empilement 4 sont formées par une sous-couche à base de nitrure de semi-conducteur, tel que du SiN, disposée entre deux sous-couches à base d'oxyde de semi-conducteur, par exemple de l'oxyde de silicium, et/ou tout autre matériau « High k ».

Sur l'exemple de la figure 1, les colonnes 6a, 6b sont régulièrement espacées les unes des autres d'une distance comprise entre environ 22 nm et 66 nm dans le cas d'une réalisation par des moyens de lithographie classique, voire d'une distance inférieure à environ 22 nm dans le cas d'une réalisation par un procédé dits « d'auto-organisation » ou par voie ascendante. Dans ce mode de réalisation, les colonnes 6a, 6b ont une forme sensiblement cylindrique et ont des dimensions sensiblement similaires les unes par rapport aux autres. Les portions de matériau semi-conducteur 8a, 8b ont par exemple une section circulaire de diamètre égal à environ 20 nm. Les couches diélectriques 12a, 12b et 14a, 14b ont par exemple une épaisseur comprise entre environ 1 nm et 10 nm. Enfin, les couches de stockage de charges électriques 10a, 10b ont par exemple une épaisseur comprise entre environ 1 nm et 10 nm. Dans un autre mode de réalisation, ces colonnes 6a, 6b pourraient avoir une section de forme différente, par exemple rectangulaire, et ne pas être de dimensions similaires, ni espacées régulièrement les unes des autres (notamment dans le cas d'une réalisation par un procédé d'auto-organisation).

Le dispositif 100 de la figure 1 comporte également une couche au moins partiellement conductrice 16, par exemple à base de carbone rendu faiblement conducteur par des particules métalliques, disposée sur l'empilement 4 et sur les sommets des colonnes 6a, 6b. La couche 16 peut également être à base de carbure de silicium (SiC) et/ou de couches minces de carbone amorphe (DLC pour « Diamond Like Carbon » en anglais). Cette couche 16 a une épaisseur comprise entre environ 2 nm et 20 nm, de telle sorte que sa conductivité permette le passage d'un courant, au niveau d'une des colonnes 6a, 6b, entre la face de la couche 16 qui n'est pas en contact avec l'empilement 4 et ladite colonne, sans court-circuiter les autres colonnes. La conductivité de la couche 16 est, par exemple, comprise entre environ 0,1 (Ω.cm)⁻¹ et 100 (Ω.cm)⁻¹. Dans une variante, la couche 16 peut également être une couche isolante, par exemple à base d'alumine, dont l'épaisseur, par exemple égale à environ 1 nm, est choisie de façon à obtenir un effet tunnel entre cette couche 16 et les colonnes 6a, 6b. Enfin, la couche 16 peut également être à base d'un matériau organique conducteur tel que du polyaniline (PANI).

Dans ce premier mode de réalisation, chaque colonne 6a, 6b comporte des zones de dopage 18a, 18b réalisées dans la portion de matériau semi-conducteur 8a, 8b, au niveau des couches isolantes 4a de l'empilement 4. Les colonnes 6a, 6b forment ainsi un ensemble de transistors de type MOS à grille flottante. Sur la figure 1, chaque colonne 6a, 6b forme trois transistors MOS à grille flottante. Les zones de dopage 18a, 18b forment les zones de source et de drain des transistors. Les transistors de chaque colonne 6a, 6b sont donc reliés en série par ces zones de source et de drain. Les couches conductrices 4b forment les grilles de commandes, et les couches de stockage de charges électriques 10a, 10b forment les grilles flottantes de ces transistors. Les zones non dopées des portions de matériau semi-conducteur 8a, 8b sont les zones de canal de ces transistors.

Enfin, le dispositif 100 comporte un circuit électronique 20 disposé sur le substrat 2. Ce circuit électronique 20 comporte des moyens d'application de tension 24 aux bornes des couches conductrices 4b de l'empilement 4. Un réseau de micro-pointes mobiles 22 (une seule micro-pointe mobile 22 est représentée sur la figure 1) permet d'appliquer une tension aux bornes des colonnes 6a, 6b, par l'intermédiaire de la couche 16. De plus, des moyens 26 de mesure du courant circulant dans les colonnes 6a, 6b sont intégrés dans le substrat 2. Ces moyens de mesure de courant 26 peuvent être spécifiques à chaque micro-pointe ou commun à l'ensemble des colonnes 6a, 6b adressées par une des micro-pointes. La mesure de courant, relative à une micro-pointe, peut être faite par exemple avec un amplificateur convertisseur courant / tension, et d'un comparateur à seuil, permettant de discriminer un niveau logique relatif au courant mesuré. Le circuit électronique 20 comporte en outre des moyens de sélection d'une ou plusieurs colonnes 6a, 6b et des moyens de sélection d'une ou plusieurs couches conductrices 4b de l'empilement 4. Ces moyens de sélection sont ici un circuit intégré réalisé en technologie CMOS qui, d'une part, sélectionne un ou plusieurs niveaux, c'est-à-dire une ou plusieurs couches conductrices 4b, en fixant le ou les potentiels appliqués sur la ou les couches 4b sélectionnées, par exemple à un potentiel « froid » tel que la masse, un potentiel « chaud » tel qu'une tension supérieure en valeur absolue à la masse, proche du potentiel appliqué par la micro-pointe aux bornes de la ou les colonnes sélectionnées, étant appliqué aux autres couches conductrices 4b non sélectionnées. Des moyens de multiplexage des adresses (des micro-pointes sélectionnées et/ou des couches conductrices 4b sélectionnées) peuvent également être intégrés dans le circuit électronique 20.

La grille flottante, formée par les couches de stockage de charges électriques 10a, 10b, de chaque transistor est l'élément de stockage d'information unitaire du dispositif 100, c'est-à-dire représente un bit de stockage. Cet élément de stockage peut également stocker plusieurs bits en multipliant le nombre de niveaux de seuil de détection possible, pour autant que la sensibilité au bruit le permette. Une information est donc écrite, lue ou effacée à la croisée d'une des colonnes 6a, 6b et d'une couche conductrice 4b, en modifiant ou en détectant la charge électrique présente à cette croisée dans la couche de stockage de charges électriques entourant ladite colonne. Ainsi, les lieux de stockage de charges électriques dans une des colonnes 6a, 6b sont définis par la présence des grilles de commande formées par les couches conductrices 4b et par les zones de canal des transistors.

Une opération d'écriture d'un bit dans le dispositif 100 de la figure 1 va maintenant être décrite.

La colonne 6a, dans laquelle le bit d'information doit par exemple être stocké, est sélectionnée par les moyens de sélection de colonne du circuit électronique 20 en positionnant la micro-pointe 22 au dessus de la colonne 6a, en contact avec la couche 16. La micro-pointe 22 applique une tension, par exemple égale à environ -5 V, aux bornes de la portion de semi-conducteur 8a. Etant donné que la micro-pointe 22 présente un potentiel négatif par rapport au matériau semi-conducteur 8a, les zones dopées 18a de chaque transistor de la colonne 6a se trouvant du côté de la micro-pointe 22 par rapport aux zones non dopées du matériau semi-conducteur 8a formant les zones de canal de ces transistors sont les zones de source de ces transistors.

Une des couches conductrices 4b est ensuite sélectionnée par les moyens de sélection de couche conductrice du circuit électronique 20 en appliquant une tension positive, par exemple égale à environ +5 V, aux bornes de la couche conductrice 4b, choisissant ainsi le transistor dans lequel le bit d'information va être stocké. Un fort champ électrique se crée au niveau de la seconde couche diélectrique 14a, permettant aux électrons se trouvant dans le canal du transistor de franchir la barrière de potentiel formée par la seconde couche diélectrique 14a par courant tunnel (effet « Fowler-Nordheim »), et ainsi de stocker une certaine charge électrique dans la couche de stockage de charges électriques 10a, au niveau de la couche conductrice 4b.

La charge stockée dans cette grille flottante induit un décalage de la caractéristique I(V) du transistor vu depuis la grille de commande, formée par la couche conductrices 4b. L'accès en lecture à ce transistor dans lequel le bit d'information a été stocké s'effectue en polarisant les grilles de commande des autres transistors de la colonne 6a, c'est-à-dire en appliquant une tension, par exemple comprise entre environ 2,2 V et 3,3 V, en fonction de la technologie mise en oeuvre, aux bornes des couches conductrices 4b autres que celle formant la grille de commande du transistor comportant l'information à lire, de manière à rendre les autres transistors de la colonne 6a passants, quel que soit leur état initial. Une tension, par exemple égale à environ 0 V, est également appliquée sur la grille de commande du transistor comportant l'information à lire. En détectant le niveau du courant circulant dans le transistor passant, il est possible de déterminer l'information contenue dans la grille flottante du transistor. Par exemple, cette information est déterminée en comparant ce niveau de courant à un seuil d'un comparateur, ou à plusieurs seuils de ce comparateur dans le cas où l'information comporte plusieurs bits.

On peut optimiser le temps d'accès en lecture et en écriture du dispositif de mémorisation en groupant les informations en mots de, par exemple, 8, 16 ou 32 bits, chaque mot étant écrit sur une colonne. Le nombre de niveaux de mémorisation des colonnes, c'est-à-dire le nombre de couches de stockage que comporte le dispositif de mémorisation, peut donc être adapté en fonction de la taille des mots d'informations écrits ou lus.

L'effacement est le processus permettant de décharger la grille flottante du transistor des électrons qui y sont stockées. Pour cela, on applique une tension négative, par exemple égale à -5 V, sur la grille de commande du transistor dans lequel est stocké l'information pour créer un champ électrique au niveau de la seconde couche diélectrique séparant la portion de matériau semi-conducteur de la couche de stockage de charges électriques. Ce champ électrique permet aux électrons stockés dans la grille flottante de traverser la seconde couche diélectrique par effet « Fowler-Nordheim » et donc d'effacer l'information contenue dans la grille flottante.

Cet effacement peut également être obtenu en appliquant une tension positive, par exemple égale à environ +5 V, sur le potentiel de source du transistor et une tension de grille nulle au transistor. Ainsi, les électrons stockés sont déchargés dans la source par courant tunnel (effet « Fowler-Nordheim »). Le potentiel du drain du transistor est laissé flottant afin de limiter le courant de fuite drain-source. Enfin, cet effacement peut également être réalisé en appliquant à la fois une tension négative sur la grille du transistor et une tension positive sur la source. On efface ainsi le contenu stocké en partie par le canal et en partie par la source.

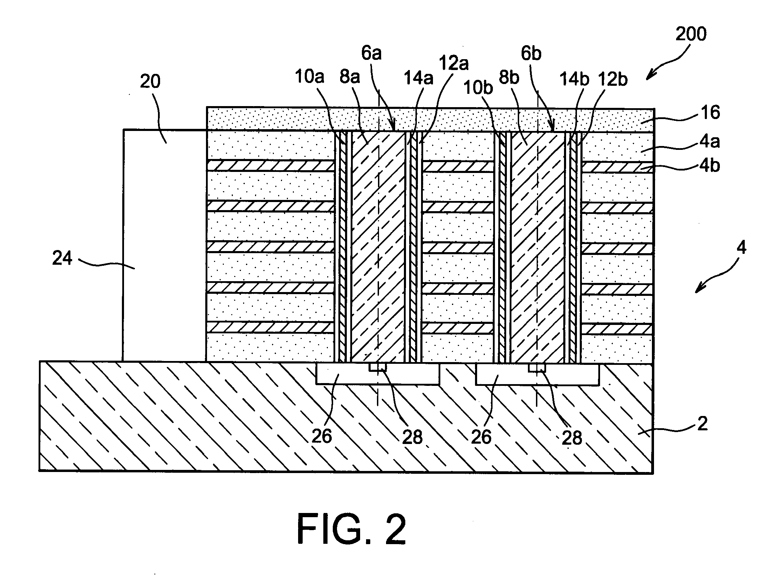

La figure 2 représente un dispositif de mémorisation de données 200 selon un second mode de réalisation.

Par rapport au dispositif 100 de la figure 1, l'empilement 4 du dispositif 200 comporte deux couches conductrices 4b et deux couches isolantes 4a supplémentaires. Toutefois, il est possible de réaliser un empilement 4 comportant un nombre supérieur ou inférieur de couches conductrices 4b et de couches isolantes 4a au nombre de ces couches des figures 1 ou 2.

Dans ce second mode de réalisation, les portions de matériau semi-conducteur 8a, 8b sont à base de nanotubes de carbone. Dans une variante, les portions de matériau semi-conducteur 8a, 8b pourraient être à base de nanofils de silicium, chaque nanofil étant dopé de manière homogène sur l'ensemble de sa structure. Les portions 8a, 8b ne comportent pas, dans ce mode de réalisation, de zones de dopage formant des zones de source et de drain de transistors. Les couches conductrices 4b servent donc ici à la fois de grilles de commande pour modifier la charge présente dans les couches de stockage de charges électriques 10a, 10b, mais également à établir la densité de porteurs dans certaines zones des portions de matériau semi-conducteur 8a, 8b des colonnes 6a, 6b, ces zones ayant un comportement similaires à des zones de drains et de sources de transistors MOS, pour permettre la formation de transistors dans les colonnes 6a, 6b. En effet, en appliquant une tension sur une des couches conductrices 4b, il s'établit une accumulation de charges libres dans la zone de la colonne 6a, 6b se trouvant en face de ladite couche conductrice 4b, ces charges étant susceptibles de migrer dans cette zone qui forme alors une zone de canal d'un transistor polarisé ou chargé sur sa grille.

Par rapport au dispositif selon le premier mode de réalisation, étant donné qu'il n'est pas nécessaire d'avoir des zones de dopage prédéfinies dans les portions de matériau semi-conducteur des colonnes, il est possible de maîtriser par champ électrostatique la présence de porteurs dans les zones des colonnes 6a, 6b se trouvant en face des couches conductrices 4b et donc de réaliser un dispositif de mémorisation 200 comportant des couches conductrices 4b et des couches isolantes 4a plus fines que celle du dispositif de mémorisation 100.

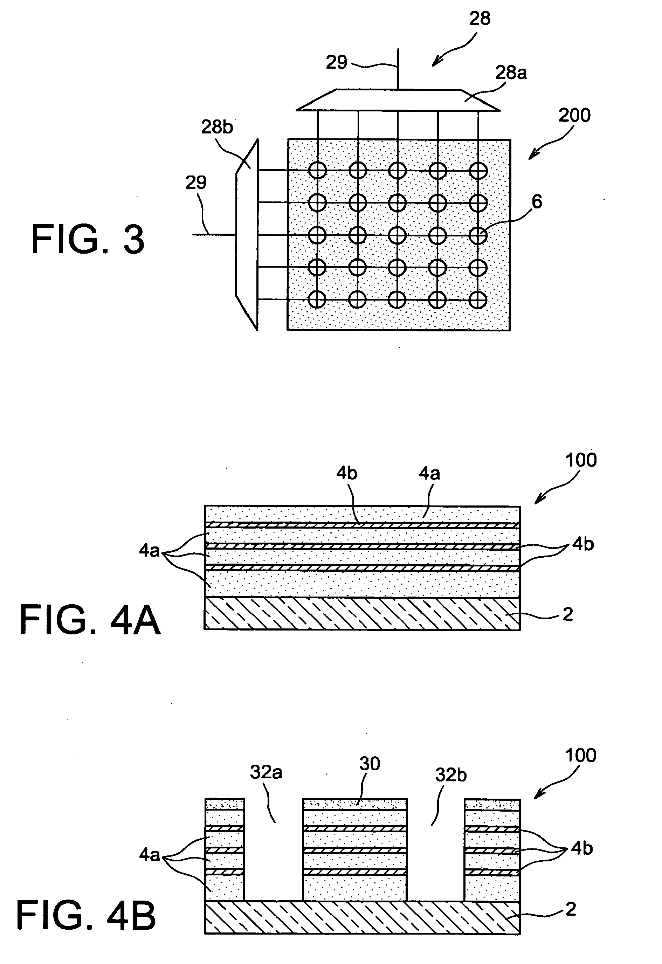

Un réseau de micro-pointes mobiles réalise l'application d'une tension aux bornes des colonnes 6a, 6b, comme dans le premier mode de réalisation décrit précédemment. La figure 3 représente une vue de dessous partielle du dispositif 200. Sur cette figure 3, seules vingt-cinq colonnes 6 sont représentées, disposées en cinq rangées de cinq colonnes. Les colonnes 6 sont reliées par le circuit de multiplexage 28, comportant deux multiplexeurs 28a, 28b, et des fils de connexion reliant chaque colonne 6 aux deux multiplexeurs 28a, 28b. Les tensions appliquées aux bornes des colonnes 6 de ce dispositif de mémorisation 200 sont appliquées par des micro-pointes.

Ce second mode de réalisation est particulièrement avantageux lorsque l'empilement 4 comporte au moins huit couches conductrices 4b et que les centres des sections des colonnes 6 sont espacés d'une distance inférieure à environ 100 nm.

Dans une variante des premier et second modes de réalisation, il est possible que les couches conductrices 4b soient réalisées, de manière alternée, avec des matériaux d'affinités électroniques différentes, par exemple des couples de deux matériaux choisis parmi du silicium polycristallin, de l'aluminium, du cuivre, du carbone ou du SiCN. Ainsi, il est possible de maîtriser les potentiels de grilles, le matériau choisi, caractérisé par son affinité électronique, fixant le potentiel de grille pour réaliser une opération de lecture, écriture ou effacement d'informations dans les colonnes se trouvant au niveau de ces couches conductrices 4b.

Un procédé de réalisation du dispositif de mémorisation 100 va maintenant être décrit en liaison avec les figures 4A à 4F.

Comme représenté sur la figure 4A, on réalise tout d'abord l'empilement 4 par des dépôts, par exemple PVD (« Physical Vapor Deposition » en anglais, ou dépôt physique en phase vapeur) alternés de couches isolantes 4a et de couches conductrices 4b sur le substrat 2. L'ensemble des éléments de fonctionnement et de contrôle du dispositif 100, c'est-à-dire le circuit électronique 20 ainsi que les moyens de mesure de courant 26, non représentés sur les figures 4A à 4F, peuvent être réalisés sur le substrat 2 avant la réalisation de l'empilement 4 (intégration « above IC »).

On structure ensuite l'empilement 4 par une étape de lithogravure. Un masque de gravure 30, par exemple à base de résine photo-sensible ou d'une couche de matériau déformée par moulage, est déposé sur l'empilement 4. La couche de matériau déformé par moulage peut être obtenue à partir d'une couche de matériau plastique déposée, par exemple par un dépôt à la tournette, sur la surface de l'empilement 4. Un moule est déposé sur cette couche plastique, puis une pression appliquée sur le moule imprime les motifs du moule sur cette couche plastique, formant alors le masque de gravure 30. Ce masque de gravure 30 peut avantageusement être réalisé par un dépôt de nanoparticules ou un mélange de constituants non miscibles à base de polymères diblock, tel que décrit dans le document « Three-Dimensional Self-Assembly of Spherical Block Copolymer Domains into V-Shaped Grooves » de V.P. Chuang et al., 2006, Nano Letters Vol. 6, N°10, pages 2332 à 2337.

Le masque 30 permet de transférer le motif définissant les emplacements des colonnes dans l'empilement 4 par un procédé de gravure tel qu'une gravure ionique ou par ions réactifs (RIE). On obtient ainsi une pluralité de trous 32a, 32b dans l'empilement 4, les trous 32a, 32b traversant l'empilement 4 jusqu'au substrat 2. Sur la figure 4B, seuls deux trous 32a, 32b sont représentés.

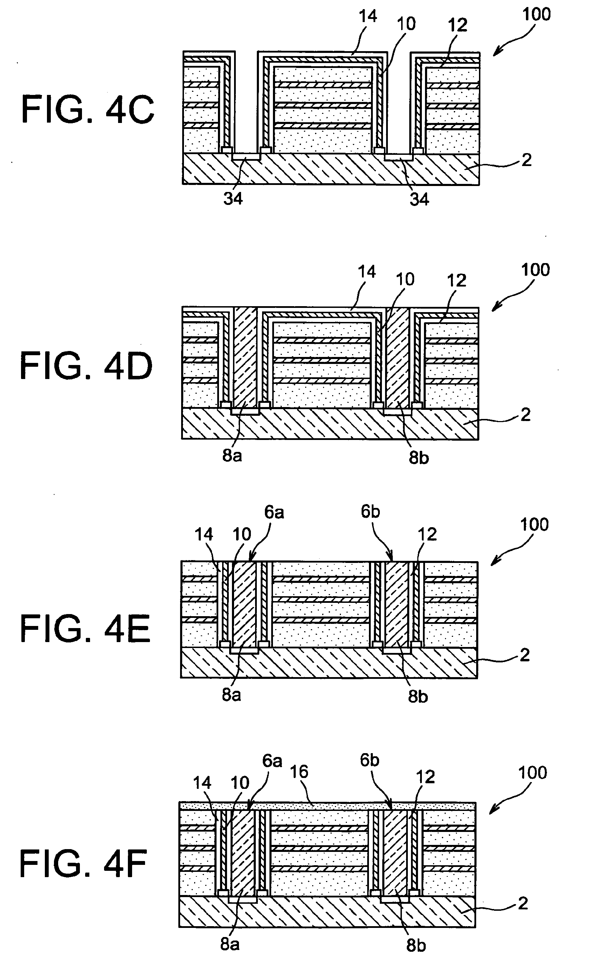

On dépose ensuite, par exemple par dépôt CVD (« Chemical Vapor Deposition » en anglais, ou dépôt chimique en phase vapeur), une première couche diélectrique 12 sur l'empilement 4 et sur les parois à l'intérieur des trous 32a, 32b. Une couche de stockage de charges électriques 10 est ensuite déposée par CVD sur la première couche diélectrique 12. La couche de stockage 10 est enfin recouverte par une seconde couche diélectrique 14 déposée par CVD (Figure 4C). Des portions des couches diélectriques 12, 14 et de la couche de stockage de charges électriques 10 se trouvant au fond des trous 32 peuvent être retirés, par exemple par gravure sèche. Un catalyseur 34, par exemple à base d'un métal tel que de l'aluminium, du nickel ou de l'or, est déposé au fond des trous 32a, 32b, afin de réaliser une croissance de nanofils de silicium formant les portions de matériau semi-conducteur 8a, 8b dans les trous 32a, 32b, formant les colonnes du dispositif de mémorisation 100 (figure 4D).

On procède ensuite à une planarisation mécano-chimique de la surface supérieure du dispositif 100, supprimant ainsi les portions des couches diélectriques 12, 14 et de la couche de stockage de charges électriques 10 ne se trouvant pas dans les trous 32 et le masque de gravure 30, comme représenté sur la figure 4E.

Enfin, comme représenté sur la figure 4F, on dépose, par exemple par pulvérisation de carbone et de particules métalliques, la couche au moins partiellement conductrice 16 sur l'ensemble du dispositif 100, cette couche 16 permettant de réduire l'usure des micro-pointes 22 lorsque celles-ci viennent en contact pour appliquer une tension aux colonnes.

Selon une variante de ce procédé de réalisation, il est possible de réaliser tout d'abord la croissance de nanofils de silicium, ou de nanotubes de carbone, sur le substrat 2, formant les portions de matériau semi-conducteur 8a, 8b, puis de les recouvrir de la seconde couche diélectrique 14, de la couche de stockage de charges électriques 10 et de la première couche diélectrique 12 par exemple par dépôt CVD et/ou oxydation d'un semi-conducteur tel que du silicium, formant les colonnes du dispositif de mémorisation. Lorsque le substrat 2 est à base de silicium d'orientation cristalline (*111*), les nanofils obtenus par croissance sont orientés sensiblement perpendiculairement par rapport à la face du substrat 2 sur laquelle est réalisée la croissance. Lorsque le substrat 2 est à base de silicium d'orientation cristalline (100), les nanofils obtenus par croissance ne sont plus orientés sensiblement perpendiculairement à ladite face du substrat 2, ce qui permet par la suite d'obtenir par exemple des transistors dans les colonnes comportant des zones de canal plus longues que celles de transistors réalisés dans des colonnes disposées perpendiculairement par rapport à ladite face du substrat 2. Ensuite, l'empilement 4 est réalisé autour des colonnes par dépôts successifs et alternés des couches isolantes 4a et conductrices 4b, par exemple par dépôt PVD (« Physical Vapor Deposition » en anglais, ou dépôt physique en phase vapeur).

## Revendications

1. Dispositif (100, 200) de mémorisation de données, comportant au moins :
- un empilement (4) de couches (4a, 4b) formé par une alternance de premières couches (4a) de conductivité inférieure à environ 0,01 (Ω.cm)⁻¹ et de secondes couches (4b) de conductivité supérieure à environ 1 (Ω.cm)⁻¹,
- une pluralité de colonnes (6, 6a, 6b) disposées dans l'empilement (4) de couches (4a, 4b), et traversant chaque couche (4a, 4b) de cet empilement (4), chacune des colonnes (6, 6a, 6b) étant formée par au moins une portion de matériau semi-conducteur (8a, 8b) entourée d'au moins une couche de stockage de charges électriques (10, 10a, 10b) isolée électriquement de la portion de matériau semi-conducteur (8a, 8b) et de l'empilement (4),
**caractérisé en ce qu'**il comporte en outre des moyens d'application de tension aux bornes des colonnes (6, 6a, 6b) comportant un réseau de micro-pointes mobiles (22).

2. Dispositif (100, 200) selon la revendication 1, les colonnes (6, 6a, 6b) traversant perpendiculairement les couches (4a, 4b) de l'empilement (4).

3. Dispositif (100, 200) selon l'une des revendications précédentes, les premières couches (4a) de l'empilement (4) étant à base d'oxyde de silicium et/ou de nitrure de silicium et/ou de tout autre matériau diélectrique de permittivité inférieure à environ 4.

4. Dispositif (100, 200) selon l'une des revendications précédentes, les secondes couches (4b) de l'empilement (4) étant à base de silicium polycristallin et/ou de métal et/ou carbone et/ou carbonitrure de silicium.

5. Dispositif (100, 200) selon l'une des revendications précédentes, les matériaux formant les secondes couches (4b) de l'empilement (4) étant, de manière alternée, des matériaux d'affinité électronique différente.

6. Dispositif (100) selon l'une des revendications précédentes, les portions de matériau semi-conducteur (8a, 8b) comportant des nanofils de silicium.

7. Dispositif (200) selon l'une des revendications 1 à 5, les portions de matériau semi-conducteur (8a, 8b) comportant des nanotubes de carbone.

8. Dispositif (100) selon l'une des revendications précédentes, la couche de stockage de charges électriques (10, 10a, 10b) comportant, au niveau des secondes couches (4b) de l'empilement (4), des portions conductrices séparées les unes des autres par des portions isolantes.

9. Dispositif (100) selon la revendication 8, les portions isolantes de la couche de stockage de charges électriques (10, 10a, 10b) étant à base d'oxyde de silicium et/ou d'oxyde d'aluminium et/ou de nitrure de silicium.

10. Dispositif (100) selon l'une des revendications 8 ou 9, les portions conductrices de la couche de stockage de charges électriques (10, 10a, 10b) étant à base silicium polycristallin et/ou de silicium-germanium et/ou de tout autre matériau électriquement conducteur.

11. Dispositif (200) selon l'une des revendications précédentes, les couches de stockage de charges électriques (10a, 10b) étant à base d'oxyde de silicium de type SiO avec x < 2 et/ou de nitrure de silicium, chargé en silicium, et/ou de tout autre matériau diélectrique de permittivité supérieure à environ 4 comportant des nanoparticules de silicium ou de tout autre matériau métallique.

12. Dispositif (100, 200) selon l'une des revendications précédentes, comportant en outre un substrat (2) à base d'au moins un matériau semi-conducteur, sur lequel est disposé l'empilement (4).

13. Dispositif (100, 200) selon la revendication 12, le substrat (2) étant à base de silicium d'orientation cristalline *(111).*

14. Dispositif (100, 200) selon l'une des revendications précédentes, la couche de stockage de charges électriques (10, 10a, 10b) de chaque colonne (6, 6a, 6b) étant isolée électriquement de l'empilement (4) par une première couche diélectrique (12, 12a, 12b) entourant ladite couche de stockage de charges électriques (10, 10a, 10b), et étant isolée électriquement de la portion de matériau semi-conducteur (8a, 8b) par une seconde couche diélectrique (14, 14a, 14b) entourant ladite portion de matériau semi-conducteur (8a, 8b).

15. Dispositif (100, 200) selon la revendication 14, la seconde couche diélectrique (14, 14a, 14b) étant à base d'oxyde de semi-conducteur tel que de l'oxyde de silicium, et/ou de nitrure de silicium et/ou de tout autre matériau diélectrique de permittivité supérieure à environ 4.

16. Dispositif (100, 200) selon l'une des revendications 14 ou 15, la première couche diélectrique (12, 12a, 12b) comportant au moins une sous-couche à base de nitrure de semi-conducteur disposée entre deux sous-couches à base d'oxyde de semi-conducteur et/ou de tout autre matériau diélectrique de permittivité supérieure à environ 4.

17. Dispositif (100, 200) selon l'une des revendications précédentes, les colonnes (6, 6a, 6b) ayant une forme sensiblement cylindrique.

18. Dispositif (100, 200) selon l'une des revendications précédentes, les colonnes (6, 6a, 6b) étant régulièrement espacées les unes des autres et/ou étant de dimensions sensiblement similaires.

19. Dispositif (100, 200) selon l'une des revendications précédentes, comportant en outre au moins une couche (16) partiellement conductrice disposée sur l'empilement (4) de couches (4a, 4b) et sur les sommets des colonnes (6, 6a, 6b).

20. Dispositif (100, 200) selon la revendication 19, la couche (16) au moins partiellement conductrice étant à base de carbone et de particules métalliques.

21. Dispositif (100, 200) selon l'une des revendications précédentes, comportant en outre :
- des moyens (24) d'application de tension aux bornes des secondes couches (4b) de l'empilement (4),
- des moyens (26) de mesure du courant destiné à circuler dans les colonnes (6, 6a, 6b).

22. Dispositif (100, 200) selon la revendication 21, comportant en outre des moyens électroniques de sélection d'une ou plusieurs colonnes (6, 6a, 6b) et/ou des moyens de sélection d'une ou plusieurs secondes couches (4b) de l'empilement (4).

23. Dispositif (100, 200) selon la revendication 22, les moyens de sélection d'une ou plusieurs colonnes (6, 6a, 6b), et/ou les moyens de sélection d'une ou plusieurs secondes couches (4b) de l'empilement (4) étant mis en oeuvre par un circuit électronique (20) réalisé sur le substrat (2).

24. Dispositif (100) selon l'une des revendications précédentes, chaque colonne (6a, 6b) comportant des zones de dopage (18a, 18b) réalisées dans la portion de matériau semi-conducteur (8a, 8b), au niveau des premières couches (4a) de l'empilement (4), et formant une pluralité de transistors de type MOS à grille flottante, les secondes couches (4b) de l'empilement (4) formant les grilles de commande et les couches de stockage de charges électriques (10, 10a, 10b) des colonnes (6a, 6b) formant les grilles flottantes de ces transistors.

25. Procédé de réalisation d'un dispositif (100, 200) de mémorisation de données, comportant au moins les étapes de :
- réalisation d'un empilement (4) de couches (4a, 4b) formé par une alternance de premières couches (4a) de conductivité inférieure à environ 0,01 (Ω.cm)⁻¹ et de secondes couches (4b) de conductivité supérieure à environ 1 (Ω.cm)⁻¹,
- réalisation de colonnes (6, 6a, 6b), chacune étant formée par au moins une portion de matériau semi-conducteur (8a, 8b) entourée d'au moins une couche de stockage de charges électriques (10, 10a, 10b) isolée électriquement de la portion de matériau semi-conducteur (8a, 8b),
- réalisation de moyens d'application de tension aux bornes des colonnes (6, 6a, 6b) comportant un réseau de micro-pointes mobiles (22),
les colonnes étant disposées dans l'empilement (4) de couches (4a, 4b), traversant chaque couche (4a, 4b) de cet empilement (4) et étant isolées électriquement de l'empilement (4), la couche de stockage de charges électriques (10, 10a, 10b) étant isolée électriquement de l'empilement (4).

26. Procédé selon la revendication 25, l'étape de réalisation de l'empilement (4) étant mise en oeuvre avant l'étape de réalisation des colonnes (6, 6a, 6b), le procédé comportant en outre, entre l'étape de réalisation de l'empilement (4) et l'étape de réalisation de colonnes (6, 6a, 6b), une étape de gravure d'une pluralité de trous (32a, 32b) dans l'empilement (4), les trous (32) traversant chaque couche (4a, 4b) de l'empilement (4), les colonnes (6, 6a, 6b) étant ensuite réalisées dans les trous (32a, 32b).

27. Procédé selon la revendication 26, la réalisation des colonnes (6, 6a, 6b) étant obtenue par au moins les étapes de :
- dépôt d'une première couche diélectrique (12, 12a, 12b) sur les parois des trous (32a, 32b) formés dans l'empilement (4) de couches (4a, 4b),
- dépôt de la couche de stockage de charges électriques (10, 10a, 10b) sur la première couche diélectrique (12, 12a, 12b),
- dépôt d'une seconde couche diélectrique (14, 14a, 14b) sur la couche de stockage de charges électriques (10, 10a, 10b),
- retrait des portions de couches diélectriques (12, 14) et de la couche de stockage de charges électriques (10) se trouvant au fond des trous (32a, 32b),
- réalisation des portions de matériau semi-conducteur (8a, 8b) dans les trous (32a, 32b).

28. Procédé selon la revendication 25, l'étape de réalisation des colonnes (6, 6a, 6b) étant mise en oeuvre avant l'étape de réalisation de l'empilement (4), les couches (4a, 4b) de l'empilement (4) étant réalisées en entourant les colonnes (6, 6a, 6b).

29. Procédé selon la revendication 28, la réalisation des colonnes (6, 6a, 6b) étant obtenue par au moins les étapes de :
- réalisation des portions de matériau semi-conducteur (8a, 8b),
- dépôt d'une couche diélectrique (14, 14a, 14b), appelée seconde couche diélectrique, au moins sur les parois latérales des portions de matériau semi-conducteur (8a, 8b),
- dépôt de la couche de stockage de charges électriques (10, 10a, 10b) sur la seconde couche diélectrique (14, 14a, 14b),
- dépôt d'une autre couche diélectrique (12, 12a, 12b), appelée première couche diélectrique, sur la couche de stockage de charges électriques (10, 10a, 10b).

30. Procédé selon l'une des revendications 27 ou 29, la réalisation des portions de matériau semi-conducteur (8a, 8b) étant une croissance de nanofils de silicium ou de nanotubes de carbone réalisée à partir d'un matériau métallique déposé par pulvérisation sur un substrat (2) à base d'au moins un matériau semi-conducteur.

31. Procédé selon l'une des revendications 25 à 30, comportant en outre une étape de dopage de zones (18a, 18b) dans les portions de matériau semi-conducteur (8a, 8b), au niveau des premières couches (4a) de l'empilement (4).

32. Procédé selon l'une des revendications 25 à 31, comportant en outre, après la réalisation de l'empilement (4) et des colonnes (6, 6a, 6b), une étape de dépôt d'une couche (16) au moins partiellement conductrice sur l'empilement (4) et sur les sommets des colonnes (6, 6a, 6b).

33. Procédé selon l'une des revendications 25 à 32, comportant en outre une étape de réalisation de moyens (24) d'application de tension aux bornes des secondes couches (4b) de l'empilement (4) et/ou une étape de réalisation de moyens de mesure du courant (26) destiné à circuler dans les colonnes (6, 6a, 6b).

34. Procédé selon l'une des revendications 25 à 33, comportant en outre une étape de réalisation de moyens de sélection d'une ou plusieurs colonnes (6, 6a, 6b) et/ou une étape de réalisation de moyens de sélection d'une ou plusieurs secondes couches (4b) de l'empilement (4).

## Claims

1. Data storage device (100, 200) comprising at least:
- a stack (4) of layers (4a, 4b) formed by an alternation of first layers (4a) with a conductivity of less than approximately 0.01 (Ω.cm)⁻¹ and second layers (4b) with a conductivity greater than approximately 1 (Ω.cm)⁻¹,
- a plurality of columns (6, 6a, 6b) disposed in the stack (4) of layers (4a, 4b), and passing through each layer (4a, 4b) in this stack (4), each of the columns (6, 6a, 6b) being formed by at least one portion of semiconductor material (8a, 8b) surrounded by least one electrical charge storage layer (10, 10a, 10b) electrically insulated from the portion of semiconductor material (8a, 8b) and from the stack (4),
**characterized in that** it further comprises means of applying voltage to the terminals of the columns (6, 6a, 6b) comprising a network of moving microspikes (22).

2. Device (100, 200) according to claim 1, the columns (6, 6a, 6b) passing perpendicularly through the layers (4a, 4b) of the stack (4).

3. Device (100, 200) according to one of the preceding claims, the first layers (4a) of the stack (4) being composed of silicon oxide and/or silicon nitride and/or any other dielectric material with a permittivity of less than approximately 4.

4. Device (100, 200) according to one of the preceding claims, the second layers (4b) of the stack (4) being composed of polycrystalline silicon and/or metal and/or carbon and/or silicon carbonitride.

5. Device (100, 200) according to one of the preceding claims, the materials forming the second layers (4b) of the stack (4) being, in alternation, materials with different electron affinities.

6. Device (100) according to one of the preceding claims, the portions of semiconductor material (8a, 8b) comprising silicon nanowires.

7. Device (200) according to one of claims 1 to 5, the portions of semiconductor material (8a, 8b) comprising carbon nanotubes.

8. Device (100) according to one of the preceding claims, the electrical charge storage layer (10, 10a, 10b) comprising, at the second layers (4b) of the stack (4), conductive portions separated from one another by insulating portions.

9. Device (100) according to claim 8, the insulating portions of the electrical charge storage layer (10, 10a, 10b) being composed of silicon oxide and/or aluminium oxide and/or silicon nitride.

10. Device (100) according to one of claims 8 or 9, the conductive portions of the electrical charge storage layer (10, 10a, 10b) being composed of polycrystalline silicon and/or silicon-germanium and/or any other electrically conductive material.

11. Device (200) according to one of the preceding claims, the electrical charge storage layers (10a, 10b) being composed of silicon oxide of the SiOₓ type with x < 2 and/or silicon nitride, containing silicon, and/or any other dielectric material with a permittivity greater than approximately 4 comprising nanoparticles of silicon or any other metal material.

12. Device (100, 200) according to one of the preceding claims, also comprising a substrate (2) composed of at least one semiconductor material, on which the stack (4) is disposed.

13. Device (100, 200) according to claim 12, the substrate (2) being composed of silicon of crystalline orientation *(111).*

14. Device (100, 200) according to one of the preceding claims, the electrical charge storage layer (10, 10a, 10b) of each column (6, 6a, 6b) being electrically insulated from the stack (4) by a first dielectric layer (12, 12a, 12b) surrounding said electrical charge storage layer (10, 10a, 10b), and being electrically insulated from the portion of semiconductor material (8a, 8b) by a second dielectric layer (14, 14a, 14b) surrounding said portion of semiconductor material (8a, 8b).

15. Device (100, 200) according to claim 14, the second dielectric layer (14, 14a, 14b) being composed of semiconductor oxide such as silicon oxide, and/or silicon nitride and/or any other dielectric material with a permittivity greater than approximately 4.

16. Device (100, 200) according to one of claims 14 or 15, the first dielectric layer (12, 12a, 12b) comprising at least one sub-layer composed of semiconductor nitride disposed between two sub-layers composed of semiconductor oxide and/or any other dielectric material with a permittivity greater than approximately 4.

17. Device (100, 200) according to one of the preceding claims, the columns (6, 6a, 6b) having a substantially cylindrical shape.

18. Device (100, 200) according to one of the preceding claims, the columns (6, 6a, 6b) being regularly spaced apart from one another and/or having substantially similar dimensions.

19. Device (100, 200) according to one of the preceding claims, also comprising at least one partially conductive layer (16) disposed on the stack (4) of layers (4a, 4b) and on the tops of the columns (6, 6a, 6b).

20. Device (100, 200) according to claim 19, the at least partially conductive layer (16) being composed of carbon and metal particles.

21. Device (100, 200) according to one of the preceding claims, also comprising:
- means (24) of applying voltage to the terminals of the second layers (4b) of the stack (4),
- means (26) of measuring the current intended to flow in the columns (6, 6a, 6b).

22. Device (100, 200) according to claim 21, also comprising electronic means for selecting one or more columns (6, 6a, 6b) and/or means of selecting one or more second layers (4b) of the stack (4).

23. Device (100, 200) according to claim 22, the means of selecting one or more columns (6, 6a, 6b) and/or the means of selecting one or more second layers (4b) of the stack (4) being implemented by an electronic circuit (20) produced on the substrate (2).

24. Device (100) according to one of the preceding claims, each column (6a, 6b) comprising doping areas (18a, 18b) produced in the portion of semiconductor material (8a, 8b), at the first layers (4a) of the stack (4), and forming a plurality of transistors of the floating-gate MOS type, the second layers (4b) of the stack (4) forming the control gates and the electrical charge storage layers (10, 10a, 10b) of the columns (6a, 6b) forming the floating gates of these transistors.

25. Method of producing a data storage device (100, 200), comprising at least the steps of:
- producing a stack (4) of layers (4a, 4b) formed by an alternation of first layers (4a) with a conductivity less than approximately 0.01 (Ω.cm)⁻¹ and second layers (4b) with a conductivity greater than approximately 1 (Ω.cm)⁻¹,
- producing columns (6, 6a, 6b), each being formed by at least one portion of semiconductor materials (8a, 8b) surrounded by at least one electrical charge storage layer (10, 10a, 10b) electrically insulated from the portion of semiconductor material (8a, 8b),
- producing means of applying voltage to the terminals of the columns (6, 6a, 6b) comprising a network of moving microspikes (22),
the columns being disposed in the stack (4) of layers (4a, 4b), passing through each layer (4a, 4b) in this stack (4) and being electrically insulated from the stack (4), the electrical charge storage layer (10, 10a, 10b) being electrically insulated from the stack (4).

26. Method according to claim 25, the step of producing the stack (4) being implemented before the step of producing the columns (6, 6a, 6b), the method also comprising, between the step of producing the stack (4) and the step of producing columns (6, 6a, 6b), a step of etching a plurality of holes (32a, 32b) in the stack (4), the holes (32) passing through each layer (4a, 4b) in the stack (4), the columns (6, 6a, 6b) then being produced in the holes (32a, 32b).

27. Method according to claim 26, the production of the columns (6, 6a, 6b) being obtained by at least the steps of:
- depositing a first dielectric layer (12, 12a, 12b) on the walls of the holes (32a, 32b) formed in the stack (4) of layers (4a, 4b),
- depositing the electrical charge storage layer (10, 10a, 10b) on the first dielectric layer (12, 12a, 12b),
- depositing a second dielectric layer (14, 14a, 14b) on the electrical charge storage layer (10, 10a, 10b),
- removing the portions of dielectric layers (12, 14) and of the electrical charge storage layer (10) situated at the bottom of the holes (32a, 32b),
- producing portions of semiconductor material (8a, 8b) in the holes (32a, 32b).

28. Method according to claim 25, the step of producing the columns (6, 6a, 6b) being implemented before the step of producing the stack (4), the layers (4a, 4b) of the stack (4) being produced by surrounding the columns (6, 6a, 6b).

29. Method according to claim 28, the production of the columns (6, 6a, 6b) being obtained by at least the steps of:
- producing portions of semiconductor material (8a, 8b),
- depositing a dielectric layer (14, 14a, 14b), called the second dielectric layer, at least on the lateral walls of the portions of semiconductor material (8a, 8b),
- depositing the electrical charge storage layer (10, 10a, 10b) on the second dielectric layer (14, 14a, 14b),
- depositing another dielectric layer (12, 12a, 12b), called the first dielectric layer, on the electrical charge storage layer (10, 10a, 10b).

30. Method according to one of claims 27 or 29, the production of the portions of semiconductor material (8a, 8b) being a growth of silicon nanowires or carbon nanotubes produced from a metal material deposited by sputtering on a substrate (2) composed of at least one semiconductor material.

31. Method according to one of claims 25 to 30, also comprising a step of doping areas (18a, 18b) in the portions of semiconductor material (8a, 8b), at the first layers (4a) of the stack (4).

32. Method according to one of claims 25 to 31, also comprising, after the production of the stack (4) and columns (6, 6a, 6b), a step of depositing at least partially conductive layer (16) on the stack (4) and on the tops of the columns (6, 6a, 6b).

33. Method according to one of claims 25 to 32, also comprising a step of producing means (24) of applying voltage to the terminals of the second layers (4b) of the stack (4) and/or a step of producing means of measuring the current (26) intended to flow in the columns (6, 6a, 6b).

34. Method according to one of claims 25 to 33, also comprising a step of producing means of selecting one or more columns (6, 6a, 6b) and/or a step of producing means of selecting one or more second layers (4b) of the stack (4).

## Patentansprüche

1. Vorrichtung (100, 200) zur Speicherung von Daten, die mindestens Folgendes umfasst:
- einen Stapel (4) von Schichten (4a, 4b), der durch einen Wechsel erster Schichten (4a) mit einer Leitfähigkeit von weniger als etwa 0,01 (Ω.cm)⁻¹ und zweiter Schichten (4b) mit einer Leitfähigkeit von mehr als etwa 1 (Ω.cm)⁻¹ gebildet ist,
- mehrere Säulen (6, 6a, 6b), die im Stapel (4) von Schichten (4a, 4b) angeordnet sind und jede Schicht (4a, 4b) dieses Stapels (4) durchqueren, wobei jede der Säulen (6, 6a, 6b) durch mindestens einen Abschnitt von Halbleitermaterial (8a, 8b) gebildet ist, der durch mindestens eine Schicht zur Speicherung elektrischer Ladungen (10, 10a, 10b) umgeben ist, die elektrisch vom Abschnitt von Halbleitermaterial (8a, 8b) und vom Stapel (4) isoliert ist,
**dadurch gekennzeichnet, dass** sie ferner Mittel zum Anlegen von Spannung an die Klemmen der Säulen (6, 6a, 6b) umfasst, die ein Netz beweglicher Mikrospitzen (22) umfassen.

2. Vorrichtung (100, 200) nach Anspruch 1, wobei die Säulen (6, 6a, 6b) die Schichten (4a, 4b) des Stapels (4) senkrecht durchqueren.

3. Vorrichtung (100, 200) nach einem der vorhergehenden Ansprüche, wobei die ersten Schichten (4a) des Stapels (4) auf Siliziumoxid und/oder Siliziumnitrid und/oder jedem anderen dielektrischen Material mit einer Dielektrizitätskonstante von unter etwa 4 basieren.

4. Vorrichtung (100, 200) nach einem der vorhergehenden Ansprüche, wobei die zweiten Schichten (4b) des Stapels (4) auf polykristallinem Silizium und/oder Metall und/oder Kohlenstoff und/oder Siliziumcarbonitrid basieren.

5. Vorrichtung (100, 200) nach einem der vorhergehenden Ansprüche, wobei die Materialien, die die zweiten Schichten (4b) des Stapels (4) bilden, wechselweise Materialien von unterschiedlicher Elektronenaffinität sind.

6. Vorrichtung (100) nach einem der vorhergehenden Ansprüche, wobei die Abschnitte von Halbleitermaterial (8a, 8b) Silizium-Nanodrähte umfassen.

7. Vorrichtung (200) nach einem der Ansprüche 1 bis 5, wobei die Abschnitte von Halbleitermaterial (8a, 8b) Kohlenstoff-Nanoröhren umfassen.

8. Vorrichtung (100) nach einem der vorhergehenden Ansprüche, wobei die Schicht zur Speicherung elektrischer Ladungen (10, 10a, 10b) in Höhe der zweiten Schichten (4b) des Stapels (4) leitfähige Abschnitte umfasst, die durch isolierende Abschnitte voneinander getrennt sind.

9. Vorrichtung (100) nach Anspruch 8, wobei die isolierenden Abschnitte der Schicht zur Speicherung elektrischer Ladungen (10, 10a, 10b) auf Siliziumoxid und/oder Aluminiumoxid und/oder Siliziumnitrid basieren.

10. Vorrichtung (100) nach einem der Ansprüche 8 oder 9, wobei die leitfähigen Abschnitte der Schicht zur Speicherung elektrischer Ladungen (10, 10a, 10b) auf polykristallinem Silizium und/oder Silizium-Germanium und/oder jedem anderen elektrisch leitfähigen Material basieren.

11. Vorrichtung (200) nach einem der vorhergehenden Ansprüche, wobei die Schichten zur Speicherung elektrischer Ladungen (10a, 10b) auf Siliziumoxid des Typs SiOₓ mit x < 2 und/oder auf Siliziumnitrid, siliziumhaltig sind, und/oder auf jedem anderen dielektrischen Material mit einer Dielektrizitätskonstante basieren, die höher ist als etwa 4, das Nanoteilchen aus Silizium oder jedem anderen metallischen Material umfasst.

12. Vorrichtung (100, 200) nach einem der vorhergehenden Ansprüche, die ferner ein Substrat (2) umfasst, das auf mindestens einem Halbleitermaterial basiert, auf dem der Stapel (4) angeordnet ist.

13. Vorrichtung (100, 200) nach Anspruch 12, wobei das Substrat (2) auf Silizium von kristalliner Orientierung *(111)* basiert.

14. Vorrichtung (100, 200) nach einem der vorhergehenden Ansprüche, wobei die Schicht zur Speicherung elektrischer Ladungen (10, 10a, 10b) jeder Säule (6, 6a, 6b) durch eine erste dielektrische Schicht (12, 12a, 12b), die die Schicht zur Speicherung elektrischer Ladungen (10, 10a, 10b) umgibt, elektrisch vom Stapel (4) isoliert ist und durch eine zweite dielektrische Schicht (14, 14a, 14b), die den Abschnitt aus Halbleitermaterial (8a, 8b) umgibt, elektrisch vom Abschnitt aus Halbleitermaterial (8a, 8b) isoliert ist.

15. Vorrichtung (100, 200) nach Anspruch 14, wobei die zweite dielektrische Schicht (14, 14a, 14b) auf Halbleiteroxid wie Siliziumoxid und/oder Siliziumnitrid und/oder jedem anderen dielektrischen Material mit einer Dielektrizitätskonstante basiert, die höher als etwa 4 ist.

16. Vorrichtung (100, 200) nach einem der Ansprüche 14 oder 15, wobei die erste dielektrische Schicht (12, 12a, 12b) mindestens eine Unterschicht umfasst, die auf Halbleiternitrid basiert und zwischen zwei Unterschichten angeordnet ist, die auf Halbleiteroxid und/oder jedem anderen dielektrischen Material mit einer Dielektrizitätskonstante basiert, die höher als etwa 4 ist.

17. Vorrichtung (100, 200) nach einem der vorhergehenden Ansprüche, wobei die Säulen (6, 6a, 6b) eine im Wesentlichen zylindrische Form aufweisen.

18. Vorrichtung (100, 200) nach einem der vorhergehenden Ansprüche, wobei die Säulen (6, 6a, 6b) in regelmäßigen Abständen voneinander angeordnet sind und/oder im Wesentlichen gleichartige Abmessungen aufweisen.

19. Vorrichtung (100, 200) nach einen der vorhergehenden Ansprüche, die ferner mindestens eine teilweise leitfähige Schicht (16) umfasst, die auf dem Stapel (4) von Schichten (4a, 4b) und auf den Spitzen der Säulen (6, 6a, 6b) angeordnet ist.

20. Vorrichtung (100, 200) nach Anspruch 19, wobei die zumindest teilweise leitfähige Schicht (16) auf Kohlenstoff und Metallteilchen basiert.

21. Vorrichtung (100, 200) nach einem der vorhergehenden Ansprüche, die ferner Folgendes umfasst:
- Mittel (24) zum Anlegen von Spannung an die Klemmen der zweiten Schichten (4b) des Stapels (4),
- Mittel (26) zum Messen des Stroms, der zum Umlaufen in den Säulen (6, 6a, 6b) bestimmt ist.

22. Vorrichtung (100, 200) nach Anspruch 21, die ferner elektronische Mittel zur Auswahl einer oder mehrerer Säulen (6, 6a, 6b) und/oder Mittel zur Auswahl einer oder mehrerer zweiter Schichten (4b) des Stapels (4) umfasst.

23. Vorrichtung (100, 200) nach Anspruch 22, wobei die Mittel zur Auswahl einer oder mehrerer Säulen (6, 6a, 6b) und/oder die Mittel zur Auswahl einer oder mehrerer zweiter Schichten (4b) des Stapels (4) durch eine auf dem Substrat (2) verwirklichte elektronische Schaltung (20) ausgeführt sind.

24. Vorrichtung (100) nach einem der vorhergehenden Ansprüche, wobei jede Säule (6a, 6b) Dotierungsbereiche (18a, 18b) umfasst, die im Abschnitt von Halbleitermaterial (8a, 8b) in Höhe der ersten Schichten (4a) des Stapels (4) verwirklicht sind und mehrere Transistoren des Typs Floating-Gate-MOS bilden, wobei die zweiten Schichten (4b) des Stapels (4) Steuergitter bilden und die Schichten zur Speicherung elektrischer Ladungen (10, 10a, 10b) der Säulen (6a, 6b) die Floating Gates dieser Transistoren bilden.

25. Verfahren zur Verwirklichung einer Vorrichtung (100, 200) zur Speicherung von Daten, das mindestens die folgenden Schritte umfasst:
- Verwirklichung eines Stapels (4) von Schichten (4a, 4b), der durch einen Wechsel erster Schichten (4a) mit einer Leitfähigkeit von weniger als etwa 0,01 (Ω.cm)⁻¹ und zweiter Schichten (4b) mit einer Leitfähigkeit von mehr als etwa 1 (Ω.cm)⁻¹ gebildet wird,
- Verwirklichung von Säulen (6, 6a, 6b), die jeweils durch mindestens einen Abschnitt von Halbleitermaterial (8a, 8b) gebildet werden, der durch mindestens eine Schicht zur Speicherung elektrischer Ladungen (10, 10a, 10b) umhüllt wird, die elektrisch vom Abschnitt von Halbleitermaterial (8a, 8b) isoliert wird,
- Verwirklichung von Mitteln zum Anlegen von Spannung an die Klemmen der Säulen (6, 6a, 6b), die ein Netz von beweglichen Mikrospitzen (22) umfassen,
wobei die Säulen im Stapel (4) der Schichten (4a, 4b) angeordnet werden, jede Schicht (4a, 4b) dieses Stapels (4) durchqueren und elektrisch vom Stapel (4) isoliert werden, wobei die Schicht zur Speicherung elektrischer Ladungen (10, 10a, 10b) elektrisch vom Stapel (4) isoliert wird.

26. Verfahren nach Anspruch 25, wobei der Schritt der Verwirklichung des Stapels (4) vor dem Schritt der Verwirklichung der Säulen (6, 6a, 6b) ausgeführt wird, wobei das Verfahren ferner zwischen dem Schritt der Verwirklichung des Stapels (4) und dem Schritt der Verwirklichung der Säulen (6, 6a, 6b) einen Schritt des Ätzens mehrerer Löcher (32a, 32b) in den Stapel (4) umfasst, wobei die Löcher (32) jede Schicht (4a, 4b) des Stapels (4) durchqueren, wobei die Säulen (6, 6a, 6b) danach in den Löchern (32a, 32b) verwirklicht werden.

27. Verfahren nach Anspruch 26, wobei die Verwirklichung der Säulen (6, 6a, 6b) mindestens mittels der folgenden Schritte erhalten wird:
- Aufbringen einer ersten dielektrischen Schicht (12, 12a, 12b) auf den Wänden der Löcher (32a, 32b), die im Stapel (4) von Schichten (4a, 4b) gebildet werden,
- Aufbringen der Schicht zur Speicherung elektrischer Ladungen (10, 10a, 10b) auf der ersten dielektrischen Schicht (12, 12a, 12b),
- Aufbringen einer zweiten dielektrischen Schicht (14, 14a, 14b) auf der Schicht zur Speicherung elektrischer Ladungen (10, 10a, 10b),
- Abtragen der Abschnitte dielektrischer Schichten (12, 14) und der Schicht zur Speicherung elektrischer Ladungen (10), die sich am Boden der Löcher (32a, 32b) befinden,
- Verwirklichung von Abschnitten aus Halbleitermaterial (8a, 8b) in den Löchern (32a, 32b).

28. Verfahren nach Anspruch 25, wobei der Schritt der Verwirklichung der Säulen (6, 6a, 6b) vor dem Schritt der Verwirklichung des Stapels (4) ausgeführt wird, wobei die Schichten (4a, 4b) des Stapels (4) durch Umhüllen der Säulen (6, 6a, 6b) verwirklicht werden.

29. Verfahren nach Anspruch 28, wobei die Verwirklichung der Säulen (6, 6a, 6b) durch mindestens die folgenden Schritte erhalten wird:
- Verwirklichung der Abschnitte aus Halbleitermaterial (8a, 8b),
- Aufbringen einer dielektrischen Schicht (14, 14a, 14b), die zweite dielektrische Schicht genannt wird, zumindest auf den seitlichen Wänden der Abschnitte aus Halbleitermaterial (8a, 8b),
- Aufbringen der Schicht zur Speicherung elektrischer Ladungen (10, 10a, 10b) auf der zweiten dielektrische Schicht (14, 14a, 14b),
- Aufbringen einer anderen dielektrischen Schicht (12, 12a, 12b), die erste dielektrische Schicht genannt wird, auf der Schicht zur Speicherung elektrischer Ladungen (10, 10a, 10b).

30. Verfahren nach einem der Ansprüche 27 oder 29, wobei die Verwirklichung der Abschnitte von Halbleitermaterial (8a, 8b) ein Wachstum von Silizium-Nanodrähten oder Kohlenstoff-Nanoröhren ausgehend von einem metallischen Material ist, das durch Zerstäubung auf einem Substrat (2) aufgebracht wird, das auf mindestens einem Halbleitermaterial basiert.

31. Verfahren nach einem der Ansprüche 25 bis 30, das ferner einen Schritt der Dotierung von Bereichen (18a, 18b) in den Abschnitten aus Halbleitermaterial (8a, 8b) in Höhe der ersten Schichten (4a) des Stapels (4) umfasst.

32. Verfahren nach einem der Ansprüche 25 bis 31, das ferner nach der Verwirklichung des Stapels (4) und der Säulen (6, 6a, 6b) einen Schritt des Auftragens einer zumindest teilweise leitfähigen Schicht (16) auf dem Stapel (4) und auf den Spitzen der Säulen (6, 6a, 6b) umfasst.

33. Verfahren nach einem der Ansprüche 25 bis 32, das ferner einen Schritt der Verwirklichung von Mitteln (24) zum Anlegen von Spannung an die Klemmen der zweiten Schichten (4b) des Stapels (4) und/oder einen Schritt der Verwirklichung von Mitteln (26) zum Messen des Stroms umfasst, der dazu bestimmt ist, in den Säulen (6, 6a, 6b) umzulaufen.

34. Verfahren nach einem der Ansprüche 25 bis 33, das ferner einen Schritt der Verwirklichung von Mitteln zur Auswahl einer oder mehrerer Säulen (6, 6a, 6b) und/oder einen Schritt der Verwirklichung von Mitteln zur Auswahl einer oder mehrerer zweiter Schichten (4b) des Stapels (4) umfasst.
